# EUROPEAN PATENT APPLICATION

(11) **EP 2 713 413 A2**
(43) Date of publication of application: **02.04.2014**
(21) Application number: 13004673.3
(22) Date of filing: 26.09.2013
(51) Int. Cl.: H01L 39/24, H01L 39/14

(54) **Nb3Sn superconducting wire and precursor of same**

(30) Priority: 28.09.2012 JP 2012217155
(71) Applicant: Kabushiki Kaisha Kobe Seiko Sho (Kobe Steel, Ltd.), Kobe-shi, Hyogo 651-8585 (JP); Japan Superconductor Technology Inc., Kitakyushu-shi Fukuoka 800-0007 (JP)
(72) Inventor: Zaitsu, Koiji, Kobe-shi, Hyogo 651-2271 (JP); Kawashima, Shinya, Kobe-shi, Hyogo 651-2271 (JP); Murakami, Yukinobu, Kitakyushu-shi, Fukuoka 800-0007 (JP); Kato, Hiroyuki, Kitakyushu-shi, Fukuoka 800-0007 (JP)
(74) Representative: Müller-Boré & Partner Patentanwälte PartG mbB

(57) **Abstract**

The precursor for production of an Nb₃Sn superconducting wire as disclosed herein is a precursor obtained by forming a composite tube into a wire, the composite tube including a cylindrical diffusion barrier layer (6) having a stabilized copper layer (4a) provided on the outer periphery thereof, and a group of wires inserted into the cylindrical diffusion barrier layer, the group of wires including an Sn core wire (3) in which an Sn or Sn-based alloy core is embedded in a Cu or Cu-based alloy matrix (4), and an Nb multi-core wire (2) in which two or more linear Nb materials (11) are embedded in a Cu or Cu-based alloy matrix (4), and the linear Nb materials (11) each including an Nb core (2a) made of Nb or an Nb-based alloy, an intermediate layer made of Ti or a Ti-based alloy (15), formed on the outside of the Nb core (2a), and an outer peripheral layer (16) made of Nb or an Nb-based alloy, formed on the outside of the intermediate layer (15).

## Description

### TECHNICAL FIELD

The present invention relates to a precursor for producing an Nb₃Sn superconducting wire (hereinafter referred to as a "precursor for production of an Nb₃Sn superconducting wire") and an Nb₃Sn superconducting wire produced from such a precursor. More specifically, the present invention relates to an Nb₃Sn superconducting wire particularly useful as a material of superconducting magnets, and a precursor of the same.

### BACKGROUND ART

The fields in which superconducting wires are put into practical use include superconducting magnets to be used in high-resolution nuclear magnetic resonance (NMR) spectrometers, nuclear fusion devices, and accelerating devices. In particular, superconducting magnets to be used in NMR spectrometers (hereinafter referred to sometimes as "NMR magnets") are required to undergo high-field magnet design and downsizing for the purpose of resolution improvement of NMR signals and time shortening of data acquisition.

For the high-field magnet design and downsizing of NMR magnets, the performance improvement of superconducting wires to be used in these magnets becomes essential, and the development of new superconducting wires has been required, which wires have characteristics exceeding those of bronze-processed Nb₃Sn superconducting wires (Nb₃Sn superconducting wires produced by the bronze process) that have hitherto been used as wires for the innermost coils of NMR magnets.

In the bronze process, two or more cores made of Nb or an Nb-based alloy are embedded in a Cu-Sn-based alloy (bronze) matrix to form a composite wire, and the composite wire is subjected to area reduction working such as extrusion or drawing, thereby making the core thinner to form an Nb-based filament, and two or more composite wires each having the Nb-based filament and the bronze are bundled together to form a group of wires, and copper for stabilization (stabilization copper) is disposed on the outer periphery thereof, followed by further area reduction working. The group of wires after the area reduction working is then heat-treated (diffusion heat-treated) at a temperature of about 600°C to about 800°C to form an Nb₃Sn compound phase (Nb₃Sn superconducting phase) on the boundary between the Nb-based filament and the bronze matrix.

However, this process has the drawback that there is a limitation to the concentration of Sn capable of forming a solid solution in the bronze (15.8% by mass or smaller), the Nb₃Sn compound phase formed has small thickness and deteriorated crystallinity, and therefore, high critical current density Jc cannot be obtained. It follows that NMR magnets can be made compact by the use of wires having high critical current density Jc.

As the process for producing Nb₃Sn superconducting wires, there have also been known the powder process using Sn or Sn-based alloy powder, and the internal diffusion process. These processes have no limitation to the concentration of Sn due to a limitation to the formation of a solid solution as in the bronze process so that the concentration of Sn can be set as high as possible and high-quality Nb₃Sn compound phase can be formed, and therefore, it is expected that high critical current density Jc can be obtained. The production of superconducting wires by the bronze method requires annealing (strain removing annealing) many times because the Cu-Sn-based alloy may cause work hardening during cold processing, but the internal diffusion process has the advantage that a precursor (precursor for production of a superconducting wire) is formed of a highly workable material such as Cu, Nb, and Sn, and therefore, annealing is not required during processing and the time for production of a precursor can be shortened.

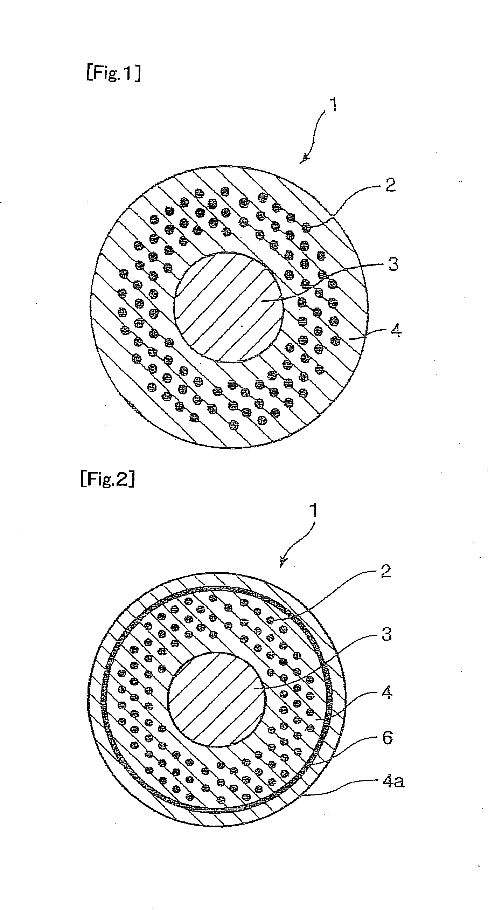

In the internal diffusion process (hereinafter referred to also as the "internal Sn process"), as shown in Fig. 1 (a schematic view of the basic structure of a precursor for production of an internal diffusion processed Nb₃Sn superconducting wire), a core made of Sn or an Sn-based alloy (hereinafter referred to sometimes as the "Sn core") 3 is embedded into the center portion of Cu or a Cu-based alloy (hereinafter referred to sometimes as the "Cu matrix") 4, and two or more cores made of Nb or an Nb-based alloy (hereinafter referred to sometimes as the "Nb core") 2 are disposed in the Cu matrix 4 around the Sn core 3 so as not to come into contact with one another to form a precursor (precursor for production of a superconducting wire) 1, which is processed by drawing and then subjected to heat treatment (diffusion heat treatment) so that Sn in the Sn core 3 diffuses and reacts with the Nb core 2 to form the Nb₃Sn compound phase in the wire.

In the precursor described above, as shown in Fig. 2, a diffusion barrier layer 6 may be disposed between the portion, in which the Nb cores 2 and the Sn core 3 are disposed, and the stabilized copper layer 4a on the outside of that portion. The whole shape of the diffusion barrier layer 6 is cylindrical (cylindrical barrier layer). The diffusion barrier layer 6 is made of, for example, an Nb layer or a Ta layer (each may be an alloy layer), or a double layer consisting of an Nb layer and a Ta layer. The diffusion barrier layer 6 prevents Sn in the Sn core 3 from diffusing externally in the diffusion heat treatment and exhibits the action of increasing the concentration of Sn in the vicinity of the Nb cores in the superconducting wire.

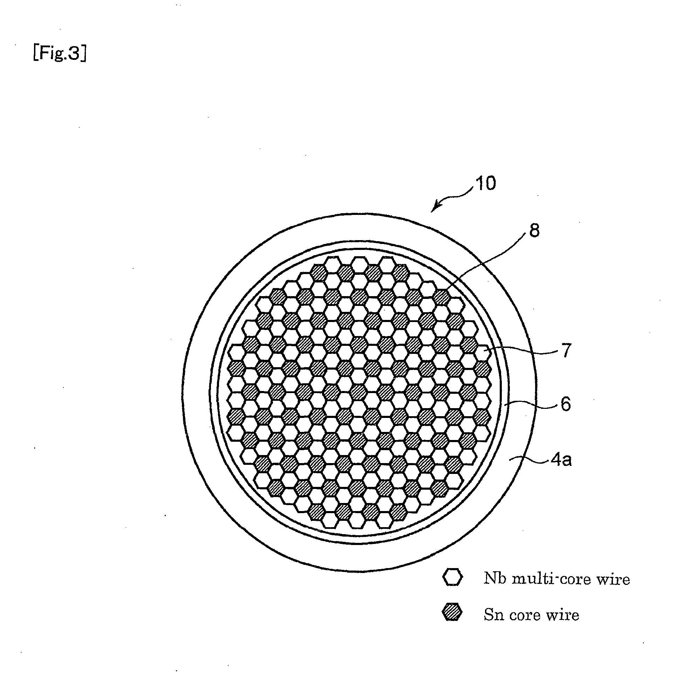

Various structures have been proposed for a precursor exhibiting satisfactory superconducting characteristics (in particular, high critical current density Jc) in the production of Nb₃Sn superconducting wires by the internal diffusion process. As one of such structures, for example, as shown in Fig. 3, a group of wires is formed by two or more Nb multi-core wires 7, in each of which Nb or Nb-based alloy cores (the Nb cores 2 shown in Figs. 1 and 2) are embedded into the Cu or Cu-based alloy matrix, and two or more Sn core wires 8, in each of which Sn or Sn-based alloy cores (the Sn cores 3 shown in Figs. 1 and 2) are embedded into the Cu or Cu-based alloy matrix, in which group of wires the Nb multi-core wires 7 are dispersively disposed so as to surround the periphery of the Sn core wire 8 (precursor 10).

In such a structure, it follows that the Nb multi-core wires 7 and the Sn core wire 8 are disposed so as to come into contact with one another. Also in the structure shown in Fig. 3, a cylindrical diffusion barrier layer 6 and a stabilized copper layer 4a may be disposed. The precursor having a structure as shown in Fig. 3 may hereinafter be referred to sometimes as the "distributed Sn superconducting wire precursor". Such a distributed Sn superconducting wire precursor can have further improved superconducting characteristics as compared with the precursors shown in Figs. 1 and 2.

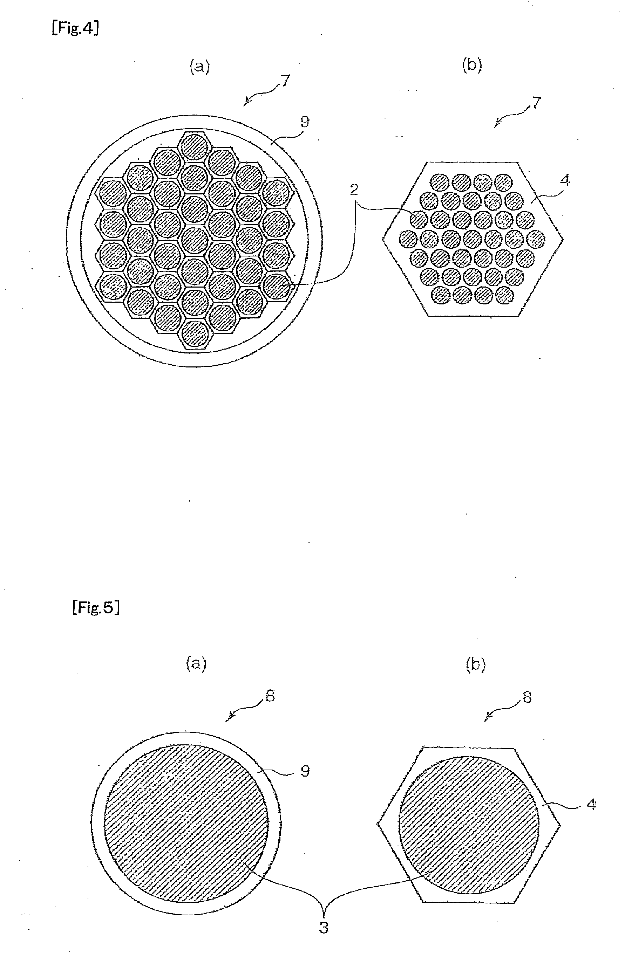

Fig. 4 is a cross-sectional view schematically showing a detailed structure of the Nb multi-core wire 7 as the constituent element of the distributed Sn superconducting wire precursor. The Nb multi-core wire 7 is formed to have a hexagonal cross-sectional shape by inserting a linear Nb or Nb-based alloy material (Nb core 2) into a pipe made of Cu or a Cu-based alloy, subjecting the inset material to reduction working such as extrusion, drawing (e.g., draw bench working), or rolling to form a composite having a hexagonal cross-sectional shape (Nb single-core wire), bundling two or more Nb single-wires (37 wires in Fig. 4) together and inserting the bundled wires into a pipe made of Cu or a Cu-based alloy [Fig. 4(a)], and subjecting the inset material to reduction working such as extrusion or drawing [Fig. 4(b): Nb multi-core wire 7]. The pipe 9 made of Cu or a Cu-based alloy forms the Cu matrix 4 after the reduction working (the same applies the case of the Sn core wire 8 shown in Fig. 5).

Fig. 5 is a cross-sectional view schematically showing the detailed structure of the Sn core wire 8 as a constituent element of the distributed Sn superconducting wire precursor described above. The Sn core wire 8 is formed to have a hexagonal cross-sectional shape by inserting an Sn or Sn-based alloy core (Sn core 3) into a pipe 9 made of Cu or a Cu-based alloy [Fig. 5(a)] and subjecting the inset material to reduction working such as extrusion or drawing [Fig. 5(b): Sn wire 8].

In the conventional distributed Sn superconducting wire precursor (as shown in Fig. 3), the Nb multi-core wires 7 shown in Fig. 4 and the Sn core wires 8 shown in Fig. 5 are disposed so as to come into contact with one another. The Nb multi-core wires 7 and the Sn core wires 8 are usually combined in the state that their cross-sectional shapes are hexagonal [Figs. 4(b) and 5(b)]. These wires may be combined as their cross-sectional shapes are circular after appropriate reduction working from the stage shown in Figs. 4(a) and 5(a).

The precursor thus obtained is subjected to heat treatment (diffusion heat treatment) to cause diffusion reaction between Nb in the Nb multi-core wires 7 or the Nb-based alloy cores (Nb cores 2) and Sn in the Sn core wires 8 or the Sn-based alloy core (Sn core 3), by which the Nb₃Sn superconducting phase is formed to produce a superconducting wire. In the superconducting wire produced with such a distributed Sn superconducting wire precursor, the Nb₃Sn superconducting phase is formed into a net-like shape, reflecting such a situation that the Nb multi-core wires 7 at the stage of a precursor are in contact with one another to form a net-like shape as a whole.

Various proposals for such a technique have been made so far, and their basic idea is to improve the characteristics of distributed Sn superconducting wires by properly adjusting the abundance ratio of Nb and Sn. As such a technique, for example, JP-A 2006-4684 discloses achieving easier processing by properly adjusting the respective numbers of modules (corresponding to the Nb multi-core wire 7 shown in Fig. 4 and the Sn core wire 8 shown in Fig. 5) or adding In to the Sn core wire. JP-A 2011-150857 discloses improving critical current density Jc by selecting a specific ratio of the Sn mole number and the Nb mole number in a precursor.

The distributed Sn superconducting wire precursors are characterized in that they have their own Nb₃Sn contents considerably higher that those of Nb₃Sn superconducting wires produced by the bronze process as the prior art process. The external magnetic field region taking the most advantage of higher Nb₃Sn contents is a magnetic field region of 17 T (tesla) or higher, i.e., a so-called high magnetic field region.

However, reviewing previously proposed techniques from the viewpoint of superconducting characteristics in the high magnetic field region, the prior art described above cannot respond to this problem. For example, the technique disclosed in JP-A 2011-150857 has an object to increase an Nb₃Sn content, but performance evaluation was carried out in the external magnetic field region of 12 T.

It is well known that the addition of the third element (such as Ti or Ta) to the Nb₃Sn phase is effective for the improvement of characteristics in the high magnetic field. For example, the technique disclosed in JP-A 2011-150857 introduces Ti into the Nb₃Sn phase by adding about 2% by mass of Ti as the third element to the Sn core and then causing a diffusion of the Ti through heat treatment. However, the current situation is as follows: The method of adding Ti to the Sn core cannot provide a sufficient amount of Ti to the Nb₃Sn phase to be increased by employing the process of forming the precursor shown in Fig. 3 (this process may hereinafter be referred to as the "distributed Sn process"). In particular, high critical current density Jc cannot be exhibited in the high magnetic field region of 18 T or higher.

In contrast, when the amount of Ti added to the Sn core according to an increase in the amount of Nb₃Sn, hard Sn-Ti compounds contained in the Sn core are present in large quantities, thereby causing a problem that breaking may occur during processing.

### DISCLOSURE OF THE INVENTION

The present invention has been completed under the circumstances described above and its object is to provide an Nb₃Sn superconducting wire and a precursor of the same, which superconducting wire can provide a sufficient amount of Ti to the Nb₃Sn phase to be increased by employing the distributed Sn process, can hardly cause breaking during processing, and can exhibit satisfactory superconducting characteristics even in the high magnetic field region.

The precursor for production of a superconducting wire according to the present invention, which can achieve the object described above, is characterized in that it is a precursor to be used in producing an Nb₃Sn superconducting wire, which precursor is obtained by forming a composite tube into a wire,
the composite tube comprising a cylindrical diffusion barrier layer having a stabilized copper layer provided on the outer periphery thereof, and a group of wires inserted into the cylindrical diffusion barrier layer,
the group of wires comprising an Sn core wire in which an Sn or Sn-based alloy core is embedded in a Cu or Cu-based alloy matrix, and an Nb multi-core wire in which two or more linear Nb materials are embedded in a Cu or Cu-based alloy matrix, and
the linear Nb materials each comprising an Nb core made of Nb or an Nb-based alloy, an intermediate layer made of Ti or a Ti-based alloy, formed on the outside of the Nb core, and an outer peripheral layer made of Nb or an Nb-based alloy, formed on the outside of the intermediate layer.

In the precursor for production of a superconducting wire according to the present invention, each of the linear Nb materials may preferably have an atomic number concentration of Ti in a range of from 2 to 6 atomic %.

More specific structures of the linear Nb materials may include (a) the structure in which the linear Nb materials each comprise the intermediate layer formed by winding a Ti or Ti-based alloy sheet, while being overlapped, on the outer periphery of the Nb core, and the outer peripheral layer formed by winding an Nb or Nb-based alloy sheet, while being overlapped, on the outer periphery of the intermediate layer; (b) the structure in which the linear Nb materials each comprise the intermediate layer formed by disposing a cylindrical member of Ti or a Ti-based alloy on the outer periphery of the Nb core, and the outer peripheral layer formed by winding a sheet made of Nb or an Nb-based alloy, while being overlapped, on the outer periphery of the intermediate layer; and (c) the structure in which the linear Nb materials each comprise the intermediate layer formed by disposing a cylindrical member of Ti or a Ti-based alloy on the outer periphery of the Nb core, and the outer peripheral layer formed by disposing a cylindrical member made of Nb or an Nb-based alloy, while being overlapped, on the outer periphery of the intermediate layer.

An Nb₃Sn superconducting wire can be produced by heat treatment of a precursor for production of an Nb₃Sn superconducting wire as described above to form an Nb₃Sn superconducting phase in the superconducting wire. The Nb₃Sn superconducting wire thus obtained can exhibit the desired characteristics (i.e., the superconducting wire can have a high critical current value in a high external magnetic field).

In the precursor for production of a superconducting wire according to the present invention, two or more linear Nb materials embedded into the Cu or Cu-based alloy matrix in the Nb multi-core wire among the group of wires in a precursor for production of a superconducting wire by the diffusion Sn method are each designed to have an intermediate layer made of Ti or a Ti-based alloy on the outer periphery of an Nb core made of Nb or an Nb-based alloy and an outer peripheral layer made of Nb or an Nb-based alloy on the outer periphery of the intermediate layer. Therefore, Nb₃Sn superconducting wires can be realized, which can exhibit satisfactory superconducting characteristics even in high magnetic field regions without forming any compound that may cause breaking during processing.

### BRIEF DESCRIPTION OF THE DRAWINGS

Fig. 1 is a cross-sectional view schematically showing a basic structural example of the precursor for production of a superconducting wire, which precursor is applied to an internal diffusion method.
Fig. 2 is a cross-sectional view schematically showing another structural example of the precursor for production of a superconducting wire, which precursor is applied to an internal diffusion method.
Fig. 3 is a cross-sectional view schematically showing a structural example of the precursor for production of a superconducting wire in the prior art (hereinafter referred to simply as the "distributed Sn superconducting wire precursor").
Fig. 4 is a cross-sectional view schematically showing the detailed structure of an Nb multi-core wire as a constituent element of the distributed Sn superconducting wire precursor.
Fig. 5 is a cross-sectional view schematically showing the detailed structure of an Sn core wire as a constituent element of the distributed Sn superconducting wire precursor.
Fig. 6 is a cross-sectional view schematically showing a structural example of the linear Nb material to be used in the present invention.
Fig. 7 is a graph showing the relationship between the external magnetic field and the critical current in the respective tests (Test Nos. 1 to 7) described in Examples.
Fig. 8 is a graph showing the relationship between the Ti concentration and the critical current when the external magnetic field is 18.0 T or 18.5 T.

### DETAILED DESCRIPTION OF THE PREFERRED EMBODIMENTS

The present inventors have made various studies from many angles on the structure of a precursor for producing a superconducting wire showing satisfactory superconducting characteristics by a distributed Sn process (hereinafter referred to as the "distributed Sn superconducting wire precursor"). As a result, the present inventors have found that the structure of the distributed Sn superconducting wire precursor, in which Ti is allowed to be present as the third element in the Nb multi-core wires as one of the constituent modules of the distributed Sn superconducting wire precursor, makes it possible to achieve a precursor fulfilling the object described above, thereby completing the present invention.

Even in the superconducting wire produced by the bronze method, there are some examples in which an Nb-Ta alloy filament is used in place of an Nb filament. The production of such an Nb-Ta alloy causes an increase in cost for obtaining a uniform material for the reason that the respective metals have extremely high melting points or other reasons, resulting in making the superconducting wire itself expensive. In contrast, the precursor of the present invention employs the structure in which Ti or a Ti-based alloy to be added to Nb is disposed in single state within a wire.

An increase in cost can be minimized by employing the structure of the present invention. More specifically, a linear Nb material to be used in producing an Nb multi-core wire is allowed to have a structure of having an intermediate layer made of Ti or a Ti-based alloy on the outer periphery of an Nb core made of Nb or an Nb-based alloy and an outer peripheral layer made of an Nb or an Nb-based alloy on the periphery of the intermediate layer. Such a structure makes it possible to achieve easier processing and high magnetic field characteristics.

The reason for employing a structure of three layers, i.e., Nb core / intermediate layer (Ti layer) / outer peripheral layer (Nb layer), in the linear Nb material of the present invention is as follows. When an Nb layer is not disposed as the outer peripheral layer, Cu disposed on the outside of an Nb multi-core wire comes into direct contact with the intermediate layer, and therefore, a hard Cu-Ti compound is produced by heat applied during the processing (e.g., heat generated by the processing, or heat applied by hot processing). The Cu-Ti compound remains in the wire without being deformed even when the periphery is subjected to area reduction processing, and therefore, the relative size of the Cu-Ti compound becomes increased with a decrease in the outer diameter of the wire, resulting in breaking. On the other hand, Ti is reacted poorly with Nb at a temperature during the processing, and if Ti would be reacted with Nb, it would take the state of an Nb-Ti alloy favorable for processing; therefore, problems such as breaking will not occur.

As described above, the arrangement of Ti in the linear Nb material makes it possible to add an element for improvement of high magnetic field characteristics, but this Ti should be added at an appropriate amount. The appropriate amount of this Ti may preferably be set, as a result of various experiments, to 2 to 6 atomic % in terms of atomic number concentration (ratio occupying the linear Nb material). Such an amount makes it possible to obtain high critical current density Jc around a high external magnetic field of not lower than 18.0 T (see Examples). This Ti concentration may more preferably be 2.2 to 5 atomic %.

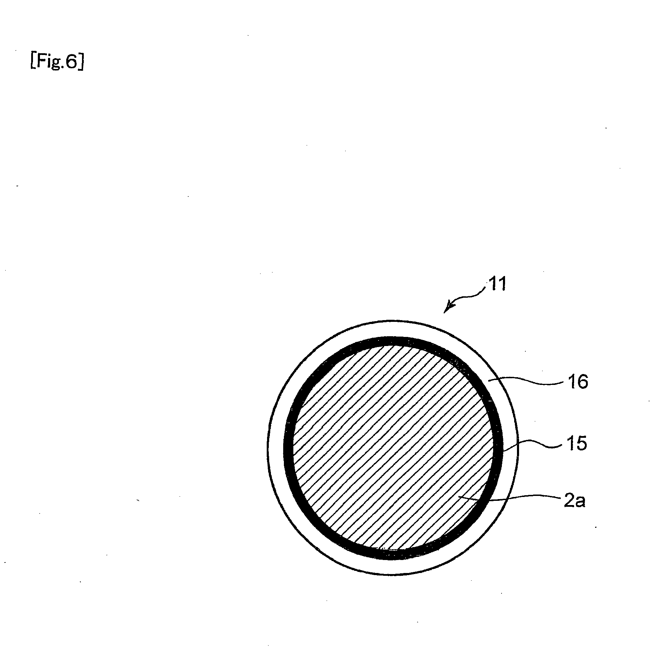

The constitution of the present invention will be described on the basis of the drawings. Fig. 6 is a cross-section view schematically showing a structural example of the linear Nb material to be used in the present invention. The linear Nb material 11 to be used in the present invention comprises an intermediate layer 15 made of Ti or a Ti alloy on the outer periphery of an Nb core 2a made of Nb or an Nb alloy, and further comprises an outer peripheral layer 16 made of Nb or an Nb-based alloy on the outer periphery of the intermediate layer 15. This linear Nb material 11 is disposed in place of the Nb core 2 shown in the prior art (Fig. 4). On the outside (i.e., on the outside of the outer peripheral layer) of the linear Nb material 11, a Cu layer is disposed, and the material is formed to have a hexagonal cross-sectional shape by reduction working such as extrusion, drawing, or rolling, two or more of which are then bundled together and embedded into a Cu or Cu-based alloy matrix to form an Nb multi-core wire (corresponding to the reference numeral "7" shown in Fig. 4). When embedded into a Cu or Cu-based alloy matrix, the materials are also formed to have a hexagonal cross-sectional shape by reduction working such as extrusion, drawing, or rolling.

The linear Nb material of the present invention may take any of the following structures: (a) the linear Nb material comprises the intermediate layer formed by winding a Ti or Ti-based alloy sheet, while being overlapped, on the outer periphery of the Nb core 2a, and the outer peripheral layer formed by winding an Nb or Nb-based alloy sheet, while being overlapped, on the outer periphery of the intermediate layer; (b) the linear Nb material comprises the intermediate layer formed by disposing a cylindrical member made of Ti or a Ti-based alloy on the outer periphery of the Nb core 2a, and the outer peripheral layer formed by winding a sheet made of Nb or an Nb-based alloy, while being overlapped, on the outer periphery of the intermediate layer; and (c) the linear Nb material comprises the intermediate layer formed by disposing a cylindrical member made of Nb or an Nb-based alloy on the outer periphery of the Nb core 2a, and the outer peripheral layer formed by disposing a cylindrical member made of Nb or an Nb-based alloy, while being overlapped, on the outer periphery of the intermediate layer.

An Nb multi-core wire is formed using the linear Nb material 11 as described above, and this Nb multi-core wire and an Sn core wire 8 as shown in Fig. 5 are disposed so as to come into contact with one another to form the precursor (the precursor for production of a superconducting wire by the diffusion Sn method) of the present invention.

Also in the precursor of the present invention, a diffusion barrier layer 6 and a stabilized copper layer 4a may be disposed in the same manner as in the prior art. For example, the diffusion barrier layer 6 can be formed of a layer made of Nb or an Nb-based alloy and/or a layer made of Ta or a Ta-based alloy (a single layer or multiple layers selected from a layer made of Nb or an Nb-based alloy or a layer made of Ta or a Ta-based alloy).

In the present invention, the precursor described above is subjected to diffusion heat treatment (usually at a temperature of about 200°C to less than 800°C) including bronze-forming heat treatment to obtain an Nb₃Sn superconducting wire exhibiting satisfactory superconducting characteristics (critical current density Jc). More specifically, bronze-forming heat treatment (diffusion of Sn into Cu) is carried out in a temperature range of 180°C to 600°C, and heat treatment forming Nb₃Sn is then carried out in a temperature range of 650°C to 750°C for about 100 to 300 hours. The bronze-forming heat treatment may be carried out as multi-stage hest treatment, for example, a combination of heat treatment at 180 °C to 200°C for about 50 hours, heat treatment around 340°C for about 50 hours, and heat treatment around 550 °C for 50 to 100 hours.

The precursor of the present invention is formed of constituent materials such as Cu or a Cu-based alloy, Nb or an Nb-based alloy, Ti or a Ti-based alloy, and Sn or an Sn-based alloy. As the Cu-based alloy to be used as the material of Cu matrix, there can be used those of which are obtained by allowing Cu to contain Cr and/or Al₂O₃ (up to about 1% by mass). As the Nb-based alloy to be used, there can be used those of which are obtained by allowing Nb to contain an additive element(s) selected from Ti, Ta, Zr, and Hf up to about 8% by mass. As the Sn-based alloy, there can be used those of which are obtained by allowing Sn to contain an additive element(s) selected from Ti and Ta to the extent of having adverse effects on workability (not greater than 3% by mass). When a Ti-based alloy is used as the intermediate layer of the linear Nb material of the present invention, or when a Ti-containing alloy is used as the Nb-based alloy to be used, the Ti concentration described above is determined taking into consideration the Ti contents of these alloys.

### EXAMPLES

The present invention will hereinafter be described more specifically by way of Examples, but the present invention is not limited to the following Examples. The present invention can be put into practice after appropriate modifications or variations within a range meeting the gist described above and below, all of which are included in the technical scope of the present invention.

On the outer periphery of an Nb rod (having an outer diameter of 26.5 mm), a Ti sheet was wound, while being overlapped, to have a different thickness (regarded as an intermediate layer thickness of X mm). On the outside of the intermediate layer, an Nb sheet was wound, while being overlapped, to have an outer diameter of 29 mm. The Nb rod thus processed was inserted into a Cu pipe (having an outer diameter of 32.8 mm and an inner diameter of 29.5 mm), followed by drawing, to produce an Nb single-core wire having a hexagonal cross-sectional shape with an opposite side length of 4 mm. The Nb single-core wire was corrected and then cut into 37 short wires, which were taken together and inserted into a Cu pipe (having an outer diameter of 32. 0 mm and an inner diameter of 29.0 mm), followed by drawing, to produce an Nb multi-core wire having a hexagonal cross-sectional shape with an opposite side length of 2 mm, which was further corrected and then cut in an appropriate length.

Then, in a Cu pipe (having an outer diameter of 24.0 mm and an inner diameter of 21.0 mm), an Sn-2 wt% Ti core (having an outer diameter of 20.5 mm) was inserted, followed by drawing, to produce an Sn core wire having a hexagonal cross-sectional shape with an opposite side length of 2 mm, which was further corrected and then cut in an appropriate length.

Then, 180 Nb multi-core wires and 73 Sn core wires, both of which had been produced above, were taken together so as to come into contact with one another to produce a group of wires. In a Cu pipe (having an outer diameter of 44.0 mm and an inner diameter of 38.0 mm), an Nb diffusion barrier layer having a thickness of 0.6 mm was disposed, and the group of wires described above was inserted into the Cu pipe thus processed, followed by drawing down to an outer diameter of 1 mm, to produce a precursor.

The precursor thus obtained was heat treated at 500°C for 100 hours to diffuse the Sn in the Sn core wire into the Cu, followed by heat treatment for Nb₃Sn formation at 700°C for 100 hours, thereby obtaining a superconducting wire. The superconducting wire after the heat treatments was immersed into liquid helium (at a temperature of 4.2 K), in which state the sample (superconducting wire) was electrified under an external magnetic field of 17.0 T, 18.0 T, or 18.5 T for measurement of generated voltage by a four-terminal method. From the characteristics thus obtained, the value of current generating en electric filed of 0.1 µV/cm (critical current Ic) was measured. The results are shown in Table 1 (as Test Nos. 1 to 7), together with the Ti layer thickness X (intermediate layer thickness) and Ti concentration (the concentration of Ti occupying the Nb material).

**TABLE 1**

| Test No. | Ti layer thickness X (mm) | Ti concentration (atomic %) | Critical current 0.1 µV/cm (A) | | |
|---|---|---|---|---|---|
| | | | 17.0 T | 18.0 T | 18.5 T |
| 1 | 0.15 | 2.0 | 203 | 150 | 130 |
| 2 | 0.25 | 3.3 | 210 | 164 | 146 |
| 3 | 0.35 | 4.6 | 207 | 160 | 142 |
| 4 | 0.45 | 5.9 | 204 | 155 | 128 |
| 5 | 0 | 0 | 200 | 143 | 121 |
| 6 | 0.10 | 1.3 | 205 | 145 | 122 |
| 7 | 0.50 | 6.6 | 199 | 144 | 123 |

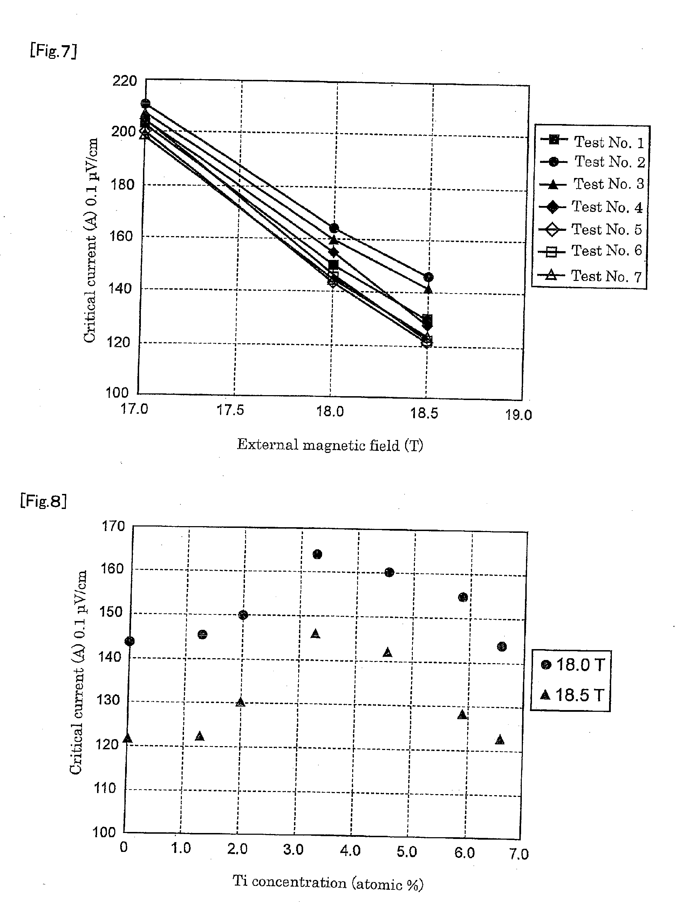

Based on the data described above, the relationship between the external magnetic field and the critical current is shown in Fig. 7 for the respective tests (Test Nos. 1 to 7), and the relationship between the Ti concentration and the critical current is shown in Fig. 8 when the external magnetic field is 18.0 T or 18.5T.

As can be seen from these results, it is found that the incorporation of Ti into the Nb multi-core wire makes it possible to obtain a high critical current value. In particular, it is found that high critical current is obtained in the samples having a Ti concentration of from 2 to 6 atomic % (Test Nos. 1 to 4).

## Claims

1. A precursor to be used in producing an Nb₃Sn superconducting wire, which precursor is obtained by forming a composite tube into a wire,
the composite tube comprising a cylindrical diffusion barrier layer having a stabilized copper layer provided on the outer periphery thereof, and a group of wires inserted into the cylindrical diffusion barrier layer,
the group of wires comprising an Sn core wire in which an Sn or Sn-based alloy core is embedded in a Cu or Cu-based alloy matrix, and an Nb multi-core wire in which two or more linear Nb materials are embedded in a Cu or Cu-based alloy matrix, and
the linear Nb materials each comprising an Nb core made of Nb or an Nb-based alloy, an intermediate layer made of Ti or a Ti-based alloy, formed on the outside of the Nb core, and an outer peripheral layer made of Nb or an Nb-based alloy, formed on the outside of the intermediate layer.

2. The precursor for production of an Nb₃Sn superconducting wire according to claim 1, wherein the linear Nb materials each have an atomic number concentration of Ti in a range of from 2 to 6 atomic %.

3. The precursor for production of an Nb₃Sn superconducting wire according to claim 1 or 2, wherein the linear Nb materials each comprise the intermediate layer formed by winding a Ti or Ti-based alloy sheet, while being overlapped, on the outer periphery of the Nb core, and the outer peripheral layer formed by winding an Nb or Nb-based alloy sheet, while being overlapped, on the outer periphery of the intermediate layer.

4. The precursor for production of an Nb₃Sn superconducting wire according to claim 1 or 2, wherein the linear Nb materials each comprise the intermediate layer formed by disposing a cylindrical member of Ti or a Ti-based alloy on the outer periphery of the Nb core, and the outer peripheral layer formed by winding a sheet made of Nb or an Nb-based alloy, while being overlapped, on the outer periphery of the intermediate layer.

5. The precursor for production of an Nb₃Sn superconducting wire according to claim 1 or 2, wherein the linear Nb materials each comprise the intermediate layer formed by disposing a cylindrical member of Ti or a Ti-based alloy on the outer periphery of the Nb core, and the outer peripheral layer formed by disposing a cylindrical member made of Nb or an Nb-based alloy, while being overlapped, on the outer periphery of the intermediate layer.

6. An Nb₃Sn superconducting wire produced by heat treatment of a precursor for production of an Nb₃Sn superconducting wire as set forth in any of claims 1 to 5 to form an Nb₃Sn superconducting phase.
